# EUROPÄISCHE PATENTSCHRIFT

(11) **EP 1 105 942 B1**
(45) Veröffentlichungstag und Bekanntmachung des Hinweises auf die Patenterteilung: **05.06.2002**
(21) Anmeldenummer: 99952416.8
(22) Anmeldetag: 16.08.1999
(51) Int. Cl.: H01R 12/22, H01R 12/04

(54) **KONTAKTIERVORRICHTUNG, INSBESONDERE ZUM ANKONTAKTIEREN VON ELEKTRISCHEN BAUELEMENTEN UND SCHALTUNGSTRÄGERN, SOWIE VERFAHREN ZU DEREN HERSTELLUNG**
CONTACT DEVICE MAINLY INTENDED FOR CONTACT BETWEEN ELECTRIC COMPONENTS AND CIRCUIT SUPPORTS AND METHOD FOR PRODUCING SAID DEVICE
DISPOSITIF D'ETABLISSEMENT DE CONTACT, EN PARTICULIER POUR L'ETABLISSEMENT DE CONTACT ENTRE DES COMPOSANTS ELECTRIQUES ET DES SUPPORTS DE CIRCUIT, AINSI QUE PROCEDE DE FABRICATION DUDIT DISPOSITIF

(30) Priorität: 17.08.1998 DE 19837246
(43) Veröffentlichungstag der Anmeldung: 13.06.2001
(73) Patentinhaber: Infineon Technologies AG, 81669 München (DE)
(72) Erfinder: WIMMER, Anton, D-83646 Bad Tölz (DE)
(74) Vertreter: Hermann, Uwe, Dipl.-Ing.
(86) Internationale Anmeldenummer: DE9902564
(87) Internationale Veröffentlichungsnummer: WO0011755

(56) Entgegenhaltungen:
- EP-A- 0 593 966
- DE-A- 3 151 933
- US-A- 3 954 317
- US-A- 4 003 621

## Beschreibung

Die vorliegende Erfindung betrifft eine Kontaktiervorrichtung, insbesondere zum Ankontaktieren von elektrischen Bauelementen in elektrischen Baugruppen an Schaltungsträgern, wie Leiterplatten, Multichipmodulen (MCM), flexiblen Schaltungen oder dergleichen, sowie ein Verfahren zur Herstellung einer Kontaktiervorrichtung.

Eine derartige Kontaktiervorrichtung ist aus EP-A-593 966 bereits bekannt, sowie einVerfahren zur Herstellung einer Kontaktiervorrichtung.

Bisher kommen bei der Fertigung von elektrischen Baugruppen zur lösbaren Ankontaktierung von gehäusten und ungehäusten Bauelementen und Displays an Schaltungsträger, wie Leiterplatten oder dergleichen, sogenannte Andruckverbinder beziehungsweise Kontaktiervorrichtungen zur Verwendung, die beispielsweise als "Leitgummi-Folien" ausgebildet sind. Hierbei handelt es sich im allgemeinen um mit metallischen- oder Kohlepartikeln gefüllte Elastomere, wodurch eine elektrische Leitfähigkeit erzeugt wird. Weiterhin kommen spezielle elastische Kontaktiervorrichtungen zum Einsatz, die mit Drahtknäueln als Kontaktelementen gefüllt sind.

Alle bekannten Kontaktiervorrichtungen haben jedoch den Nachteil, daß sie teilweise außerordentlich hohe Anpreßkräfte erfordern, um eine einigermaßen gute Ankontaktierung zu gewährleisten. Weiterhin weisen die bekannten Vorrichtungen relativ hohe Übergangs- und Innenwiderstände auf. Schließlich kann mit den bekannten Vorrichtungen eine Ankontaktierung von Bauelementen in Vertiefungen der Schaltungsträger, wie sie beispielsweise bei mit Lötstopplack versehenen Oberflächen vorhanden sind, nur unzureichend realisiert werden.

Ausgehend vom bekannten Stand der Technik liegt der vorliegenden Erfindung die Aufgabe zugrunde, eine Kontaktiervorrichtung bereitzustellen, bei der die genannten Nachteile vermieden werden. Insbesondere soll eine Kontaktiervorrichtung bereitgestellt werden, mit der eine sichere, kostengünstige und sehr genaue Ankontaktierung von elektrischen Bauelementen an Schaltungsträger möglich wird. Weiterhin soll ein geeignetes Verfahren zur Herstellung einer Kontaktiervorrichtung bereitgestellt werden.

Die Aufgabe wird gemäß einem ersten Aspekt der Erfindung durch eine Kontaktiervorrichtung, insbesondere zum Ankontaktieren von elektrischen Bauelementen an Schaltungsträger gemäß Anspruch 1, gelöst.

Die erfindungsgemäße elastische Kontaktiervorrichtung zeichnet sich zunächst dadurch aus, daß eine hohe Kontaktiersicherheit gewährleistet wird. Gleichzeitig können die notwendigen Kontaktkräfte relativ gering gehalten werden. Dies führt zu einer Reduzierung des Risikos von Beschädigungen der Bauelemente und der Kontaktiervorrichtung. Weiterhin kann die Kontaktiervorrichtung dem entsprechenden Design und Layout der anzukontaktierenden Bauelemente angepaßt werden. Sie ist elastisch, kann auch kleinste Anschlußraster und Kontaktflächen bedienen und ist kostengünstig in hohen Stückzahlen herstellbar. Darüber hinaus ist eine gezielte Ankontaktierung der jeweiligen Kontaktpunkte an den Bauelementen und Schaltungsträgern möglich.

Die Kontaktiervorrichtung kann nahezu größenunabhängig in modernen Leiterplatten- und MCM-Fertigungen hergestellt werden, da sie eine ähnliche Struktur aufweist.

Die Kontaktiervorrichtung stellt insbesondere eine lösbare elektrische Verbindung von Bauelementen und Schaltungsträgern dar, die es gestattet, daß einzelne Bauelemente ausgetauscht oder ersetzt werden können.

Die Verbindungen innerhalb des elastischen elektrischen Andruckverbinders können beispielsweise mittels der sogenannten "Micro-Via-Technik", etwa durch Laserstrukrurierung oder dergleichen, hergestellt werden.

Die Art und Weise der Ausgestaltung der einzelnen Verbindungen innerhalb des elastischen elektrischen Andruckverbinders, eine mögliche Verknüpfung der Verbindungen untereinander sowie die Verknüpfung der Verbindungen mit den einzelnen Kontaktpunkten kann je nach Anwendungsgebiet und Bedarf vorgenommen werden. Einzelne Beispiele, die jedoch rein exemplarischer Natur sind und nicht ausschließend zu verstehen sind, werden weiter unten in größerem Detail beschrieben.

Bevorzugte Ausgestaltungsformen der erfindungsgemäßen Kontaktiervorrichtung ergeben sich aus den rückbezogenen Unteransprüchen.

Erfindungsgemäß kann das elastische Dielektrikum aus Silikonkautschuk oder Polyurethan gebildet sein. Natürlich ist die Erfindung nicht auf die Verwendung dieser beiden Materialien beschränkt. Vielmehr kann jedes Material verwendet werden, daß zum einen elastisch, und zum anderen elektrisch isolierend ist.

In weiterer Ausgestaltung können die Kontaktpunkte jeweils die Ebene der Oberseite und Unterseite des elektrischen Andruckverbinders überragen. Dadurch lassen sich zum einen Niveau-Unterschiede in den Oberflächen der anzukontaktierenden Bauelemente, Schaltungsträger und dergleichen auf einfache Weise ausgleichen. Darüber hinaus kann auf zuverlässige und sichere Weise auch eine Ankontaktierung in Vertiefungen der Bauelemente und Schaltungsträger vorgenommen werden, was mit den bisher bekannten Kontaktiervorrichtungen nur unzureichend möglich war.

Vorteilhaft können die Oberflächen der Kontaktpunkte einen Metallüberzug, vorzugsweise einen Goldüberzug, aufweisen. Dadurch wird die Kontaktiersicherheit weiter erhöht. Natürlich sind auch andere Metalle als Überzug denkbar.

Erfindungsgemäß können einzelne Kontaktpunkte, die jeweils auf der Oberseite und Unterseite des elektrischen Andruckverbinders angeordnet sind, über die Verbindungen miteinander verbunden sein. In bevorzugter Ausgestaltung sind jeweils solche Kontaktpunkte, die an jeweils direkt gegenüberliegenden Positionen auf der Oberseite und Unterseite des elektrischen Andruckverbinders angeordnet sind, über die Verbindungen miteinander verbunden. Je nach Bedarf und Anwendungsfall kann es aber auch sinnvoll sein, jeweils versetzt zueinander auf der Oberseite und Unterseite befindliche Kontaktpunkte über die Verbindungen miteinander zu verbinden. Die vorliegende Erfindung ist auf keine spezielle Verschaltung der einzelnen Kontaktpunkte auf der Oberseite und Unterseite des elektrischen Andruckverbinders beschränkt. Vielmehr ergibt sich die erforderliche Verschaltung aus den zu bedienenden Anschlußrastern und Kontaktflächen der anzukontaktierenden Bauelemente.

In weiterer Ausgestaltung können einzelne Kontaktpunkte, die auf der Oberseite und/oder der Unterseite des elektrischen Andruckverbinders jeweils nebeneinander angeordnet sind, über die Verbindungen miteinander verbunden sein. Dadurch können noch einfacher auch kleinste Anschlußraster und Kontaktflächen der Bauelemente bedient werden.

Vorteilhaft können die Verbindungen im elektrischen Andruckverbinder ein dreidimensionales Schaltungssystem bilden. Dadurch kann auch der sogenannte "Translator-Effekt" genutzt werden, falls dies erforderlich ist. Ein solcher "Translator-Effekt" wird insbesondere dann benötigt, wenn am anzukontaktierenden Bauelement ein sehr feines Anschlußraster vorliegt, während der Schaltungsträger ein gröberes Raster aufweist. Durch das dreidimensionale Schaltungssystem läßt sich die Kontaktiersicherheit weiter erhöhen. Zusätzlich kann ein und dieselbe Kontaktiervorrichtung universell auch zum Ankontaktieren von unterschiedlichsten Bauelementen verwendet werden.

Bevorzugt kann das dreidimensionale Schaltungssystem eine Mäanderform aufweisen.

In weiterer Ausgestaltung können wenigstens einige der Verbindungen in lösbarem Kontakt zu anderen Verbindungen im elektrischen Andruckverbinder angeordnet sein. Dadurch kann die Verknüpfung der elektrisch leitenden Verbindungen innerhalb des elastischen elektrischen Andruckverbinders je nach herrschender Kontaktkraft variieren. Das bedeutet, daß innerhalb des elektrischen Andruckverbinders unterschiedliche Strukturen des dreidimensionalen Schaltungssystems erzeugt werden können. Dadurch ist eine Variation der Verbindung von einzelnen Kontaktpunkten möglich, wodurch die Flexibilität beim Ankontaktieren verschiedener Bauelemente, sowie die Kontaktiersicherheit weiter erhöht wird.

Erfindungsgemäß kann der elektrische Andruckverbinder aus einer oder mehreren Schichten eines elastischen Dielektrikums gebildet sein. Je nach Bedarf können somit dickere oder dünnere Kontaktiervorrichtungen geschaffen werden, wodurch größere Niveaudifferenzen zwischen den einzelnen Bauelementen und Schaltungsträgern besser ausgeglichen werden können.

Der Schaltungsträger weist auf der Oberseite und/oder Unterseite eine elektrisch leitende Schicht, vorzugsweise eine Metallschicht, auf. Ein bevorzugtes Metall ist Kupfer, allerdings sind auch andere Metalle denkbar, die als elektrische Leiter geeignet sind. Weiterhin kann die Schicht auch aus anderen elektrisch leitenden Materialien und Zusammensetzungen hergestellt sein. Als Beispiel hierfür ist unter anderem Silberleitkleber zu nennen.

Bei Verwendung von zwei oder mehr Dielektrikumsschichten können auch diese auf der Oberseite und/oder der Unterseite eine elektrisch leitende Schicht, vorzugsweise eine Metallschicht, aufweisen. Auch hier ist die Verwendung der vorstehend genannten Materialien denkbar und möglich.

Bevorzugt kann die elektrisch leitende Schicht als Folie ausgebildet sein. Sie kann jedoch auch durch Siebdruck, eine spezielle Lackierung oder dergleichen gebildet werden.

In weiterer Ausgestaltung können auf der Oberseite und/oder der Unterseite des elektrischen Andruckverbinders eine oder mehrere Schichten einer Fotofolie vorgesehen sein.

Erfindungsgemäß können die Verbindungen, die in dem elektrischen Andruckverbinder angeordnet sind, über eine Strukturierung der Dielektrikumsschicht(en), sofern vorhanden der elektrisch leitenden Schicht(en) und sofern vorhanden der Fotofolie(n) ausgebildet sein. Somit können die Verbindungen beispielsweise in "Micro-Via-Technik", etwa mittels Laserstrukturierung, ähnlich wie bei der Fertigung moderner Leiterplatten, hergestellt werden. Dadurch kann die erfindungsgemäße Kontaktiervorrichtung auf besonders kostengünstige Weise hergestellt werden.

Erfindungsgemäß können die Kontaktpunkte und/oder die Metallschicht(en) galvanisch aufgeformt sein. Weiterhin können auch die Verbindungen innerhalb des elektrischen Andruckverbinders galvanisch erzeugt sein. Anstelle einer galvanischen Erzeugung der genannten Elemente sind auch andere Erzeugungsarten, wie beispielsweise Leitpastendruck oder dergleichen, möglich.

Durch die erfindungsgemäße Kontaktiervorrichtung können elektrische Bauelemente auf einfache und sichere Weise ankontaktiert werden. Die erforderliche Kontaktkraft sowie der erforderliche Kontaktweg der einzelnen Kontaktpunkte können über die Elastizität des Dielektrikums und die Ausgestaltung des aus den Verbindungen bestehenden Schaltungssystems -und hierdurch beispielsweise durch die Anzahl der vorhandenen Translatorlagen- eingestellt und an die vorherrschenden Gegebenheiten angepaßt werden.

Die Kontaktiervorrichtung kann auch als BGA (ball grid array) oder Mikro-BGA ausgeführt werden, was eine kostengünstige Montage von billigen Produkten und Produkten mit großem Volumen ermöglicht.

Gemäß einem zweiten Aspekt der vorliegenden Erfindung wird ein Verfahren gemäß Anspruch 9 zur Herstellung einer Kontaktiervorrichtung, vorzugsweise zum Ankontaktieren von elektrischen Bauelementen an Schaltungsträger, insbesondere zur Herstellung einer wie vorstehend beschriebenen erfindungsgemäßen Kontaktiervorrichtung bereitgestellt.

Durch das erfindungsgemäße Verfahren lassen sich auf einfache und kostengünstige Weise die vorstehend beschriebenen Kontaktiervorrichtungen herstellen. Zu den Vorteilen, Wirkungen, Effekten und der Funktionsweise des Verfahrens wird auf die obigen Ausführungen zur Kontaktiervorrichtung vollinhaltlich Bezug genommen und hiermit verwiesen.

Die Herstellung des elektrischen Andruckverbinders kann beispielsweise durch Beschichten einer elektrisch leitenden Schicht, etwa einer Metallschicht und hier insbesondere einer Kupferschicht, mit einem flüssigen Dielektrikumsmaterial erfolgen. Die Beschichtung kann durch Gießen (wie bei Lötstopplack), Sprühen, Schleudern, Walzen oder ähnlichen Verfahren erfolgen. Auch ein Auflaminieren von teilpolymerisierten Dielektrikumsfolien ist möglich. Anschließend wird auf das Dielektrikumsmaterial auf der der ersten Metallschicht gegenüberliegenden Seite eine zweite Metallschicht aufgebracht und das Dielektrikum ausgehärtet. Dann kann die Strukturierung der Verbindungen vorgenommen werden.

Bevorzugte Ausführungsformen des erfindungsgemäßen Verfahrens ergeben sich aus den rückbezogenen Unteransprüchen.

Erfindungsgemäß können zwei oder mehr Schichten eines elastischen Dielektrikums hergestellt werden, die auf der Oberseite und/oder Unterseite mit einer elektrisch leitenden Schicht beschichtet werden. Die einzelnen Schichten des Dielektrikums werden nach ihrer Strukturierung zur Herstellung des elektrischen Andruckverbinders miteinander verbunden.

Dadurch können auch dickere Kontaktiervorrichtungen geschaffen werden, die insbesondere beim Ausgleich größerer Niveaudifferenzen der einzelnen Bauelemente von Vorteil sind. Die Anzahl der erforderlichen Schichten ergibt sich je nach Bedarf und Anwendungsfall.

In weiterer Ausgestaltung kann die Oberseite und/oder die Unterseite der Dielektrikumsschicht(en) mit wenigstens einer Fotofolie beschichtet werden. Die Anzahl der zu verwendenden Lagen an Fotofolie ergibt sich je nach Bedarf. Die Fotofolie(n) kann als Schutz der darunter befindlichen Bauteile dienen. Sie kann auch zur Struktuierung der einzelnen Verbindungen herangezogen werden.

Vorteilhaft kann die Strukturierung der Dielektrikumsschicht(en) und/oder der elektrisch leitenden Schicht(en) und/oder der Fotofolie(n) durch Laserstrukturierung - beispielsweise mittels Laserbohren- und/oder durch Photostrukturierung und/oder durch Ätzstrukturierung erfolgen. Allerdings sind auch andere Strukturierungsarten denkbar.

Erfindungsgemäß können die Kontaktpunkte galvanisch auf der Oberseite und Unterseite des Schaltungsträgers aufgebaut werden. Es sind aber auch die wie weiter oben beschriebenen anderen Erzeugungsarten denkbar.

Vorteilhaft können die Kontaktpunkte mit einer Metallschicht, beispielsweise einer Goldschicht, beschichtet werden.

In weiterer Ausgestaltung können die einzelnen Dielektrikumsschichten über die Metallschicht(en) zur Bildung des elektrischen Andruckverbinders ankontaktiert werden.

Die Erfindung wird nun anhand von Ausführungsbeispielen unter Bezugnahme auf die beiliegende Zeichnung näher erläutert. Es zeigt:
Fig.1 eine Anordnung eines elektrischen Bauelements und eines Schaltungsträgers, die über eine erfindungsgemäße Kontaktiervorrichtung aneinander ankontaktiert sind;
Fig.2 eine weitere Ausführungsform der erfindungsgemäßen Kontaktiervorrichtung;
Fig.3 eine andere Ausführungsform der erfindungsgemäßen Kontaktiervorrichtung in ihrer Ausgangshöhe vor dem Ankontaktieren; und
Fig.4 eine Kontaktiervorrichtung gemäß Fig.3 in ihrer Kontaktierhöhe nach dem Ankontaktieren.

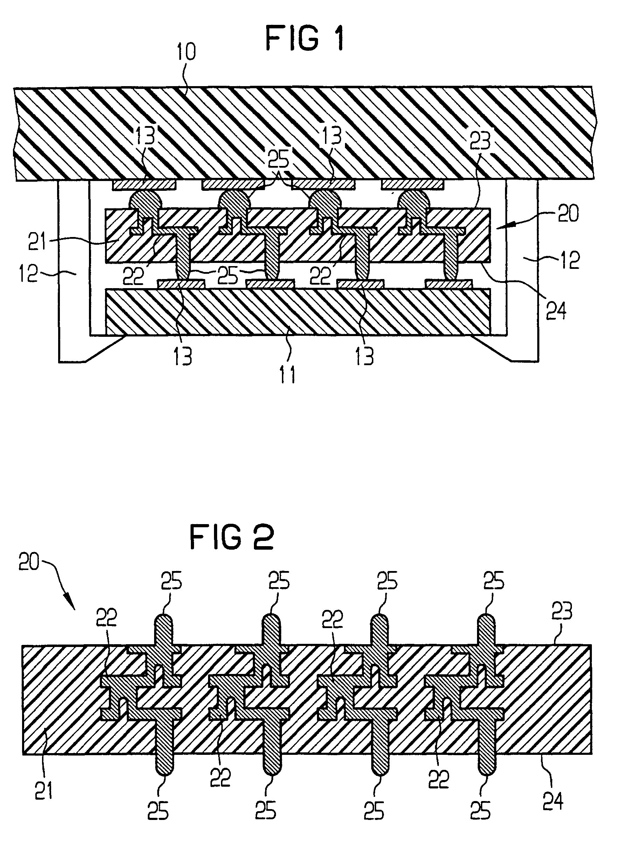

In Fig.1 ist eine Leiterplatte 10 dargestellt, die über eine Kontaktiervorrichtung 20 an einem elektrischen Bauelement 11 ankontaktiert ist. Zur Erzeugung einer ausreichenden Kontaktkraft sind an beiden Seiten der Kontaktiervorrichtung 20 Halteelemente 12 vorgesehen.

Sowohl die Leiterplatte 10, als auch das elektrische Bauelement 11 weisen ein Kontaktraster mit einer Vielzahl von Kontakten 13 auf. Die einzelnen Kontakte 13 sind über die Kontaktiervorrichtung 20 miteinander verbunden.

Dazu weist die Kontaktiervorrichtung 20 einen elektrischen Andruckverbinder 21 auf, der ein elastisches Dielektrikum aufweist. Weiterhin weist der elektrische Andruckverbinder 21 eine Anzahl von elektrisch leitenden Verbindungen 22 auf. Die Verbindungen 22 verbinden jeweils eine Anzahl von Kontaktpunkten 25, die auf der Oberseite 23 und der Unterseite 24 des elektrischen Andruckverbinders 21 angeordnet sind. Die Kontaktpunkte 25 stehen jeweils mit den Kontakten 13 der Leiterplatte 10 und des elektrischen Bauelements 11 in Verbindung, wodurch die lösbare Ankontaktierung des Bauelements 11 an der Leiterplatte 10 ermöglicht wird. Die Kontaktpunkte 25 überragen die Ebene der Oberseite 23 und Unterseite 24, wodurch auch eine Ankontaktierung in Vertiefungen der entsprecheneden elektrischen Bauelemente 10, 11 möglich wird.

In Fig.2 ist eine andere Ausführungsform der Kontaktiervorrichtung 20 dargestellt. Wie bei der in Fig.1 dargestellten Ausführungsform sind auch in Fig.2 jeweils solche Kontaktpunkte 25 über Verbindungen 22 miteinander verbunden, die direkt gegenüberliegend auf der Oberseite 23 und der Unterseite 24 des elektrischen Andruckverbinders 21 angeordnet sind. Im Unterschied zu Fig.1 sind die Verbindungen 22 jedoch anders ausgebildet, so daß sich innerhalb des elektrischen Andruckverbinders 21 ein anderes, durch die Verbindungen 22 gebildetes dreidimensionales Schaltungssystem ergibt. Die Ausgestaltung der jeweils geeigneten Schaltungssysteme ergibt sich je nach Anwendungsfall.

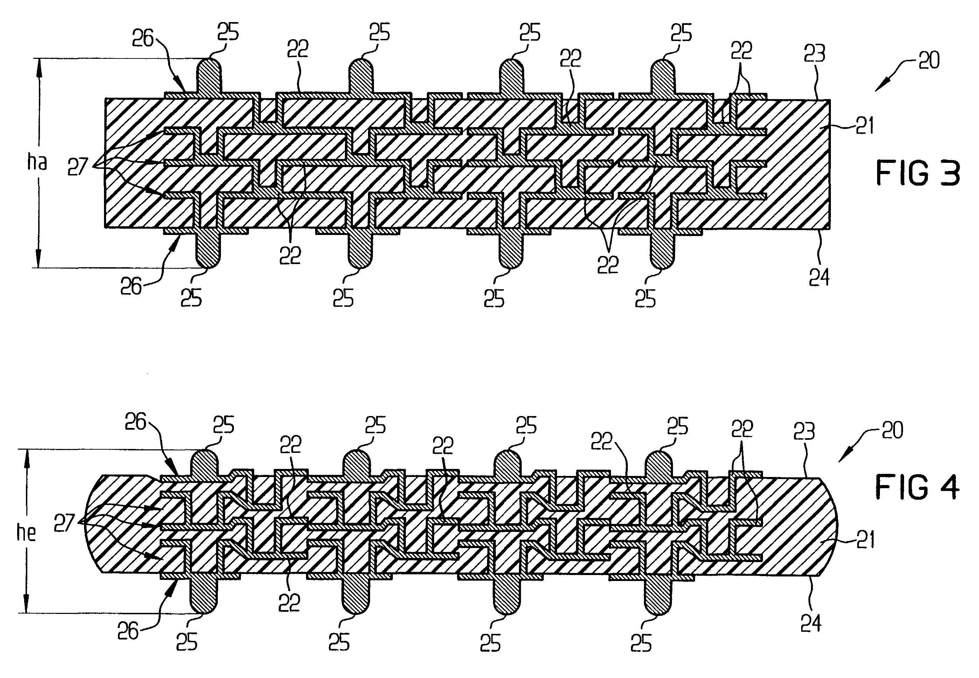

In den Fig.3 und 4 ist noch ein weiteres Ausführungsbeispiel einer erfindungsgemäßen Kontaktiervorrichtung 20 dargestellt.

Fig.3 zeigt die Kontaktiervorrichtung 20 vor dem eigentlichen Ankontaktiervorgang mit einer Ausgangshöhe "ha". Der elektrische Andruckverbinder 21 weist mehrere Schichten eines elastischen Dielektrikums auf. Die einzelnen Dielektrikumsschichten sind an ihrer Oberseite und Unterseite jeweils mit einer Metallschicht 27 beschichtet. Außerdem ist der gesamte elektrische Andruckverbinder 21 auf seiner Oberseite 23 und seiner Unterseite 24 mit einer Metallschicht 26 beschichtet.

Weiterhin sind auf der Oberseite 23 und der Unterseite 24 des elektrischen Andruckverbinders 21 eine Vielzahl von Kontaktpunkten 25 vorgesehen. Die einzelnen Metallschichten 26 und 27 sowie die Dielektrikumsschichten sind strukturiert und bilden ein dreidimensionales Schaltungssystem, das aus den einzelnen Verbindungen 22 besteht. Über das aus den Verbindungen 22 gebildete Schaltungssystem sind sowohl solche Kontaktpunkte 25, die auf der jeweils gegenüberliegenden Oberseite 23 und Unterseite 24 des elektrischen Andruckverbinders 21 angeordnet sind, als auch solche Kontaktpunkte 25 untereinander verbunden, die entweder auf der Oberseite 23 oder der Unterseite 24 jeweils nebeneinander angeordnet sind. Resultierend entsteht eine Kontaktiervorrichtung, die universell für verschiedene Bauelemente mit unterschiedlichen Anschlußrastern und Kontaktflächen ausgebildet sind. Durch die besondere Ausgestaltung des dreidimensionalen Schaltungssystems kann der sogenannte "Translator-Effekt" erzeugt werden, wodurch Bauelemente und Kontaktiervorrichtungen mit unterschiedlichen Rasterungen der Kontaktpunkte dennoch zufriedenstellend aneinander ankontaktiert werden können.

Nach erfolgter Kontaktierung und dem Aufbringen einer geeigneten Kontaktkraft wird die Kontaktiervorrichtung 20 in die Kontaktierhöhe "he" zusammengedrückt, wie dies in Fig.4 dargestellt ist. Durch das Zusammendrücken des elektrischen Andruckverbinders 21 werden die das dreidimensionale Schaltungssystem bildenden Verbindungen 22 verschoben. Es resultiert ein dreidimensionales Schaltungssystem, bei dem im Zustand der Ankontaktierung die sich jeweils direkt gegenüberliegenden Kontaktpunkte 25 auf der Oberseite 23 und der Unterseite 24 des elektrischen Andruckverbinders 21 über die Verbindungen 22 elektrisch miteinander verbunden sind.

Bei geringerer Kontaktkraft oder bei einer Kontaktkraft, die über der gesamten Breite der Kontaktiervorrichtung unterschiedlich stark ausgebildet ist, läßt sich zumindest in Teilbereichen des elektrischen Andruckverbinders 21 ein Schaltungssystem erzeugen, bei dem auch benachbarte oder zueinander versetzt angeordnete Kontaktpunkte 25 über die Verbindungen 22 miteinander verbunden sind. Dadurch läßt sich die Struktur des durch die Verbindungen 22 im elektrischen Andruckverbinder 21 gebildeten dreidimensionalen Schaltungssystems über die Elastizität des Dielektrikums -und damit des elektrischen Andruckverbinders 21-, sowie über die Stärke der wirkenden Kontaktkraft je nach Bedarf einstellen und gegebenenfalls verändern.

Nachfolgend wird ein Beispiel für ein Herstellungsverfahren einer erfindungsgemäßen Kontaktiervorrichtung beschrieben. Zunächst wird eine dünne Kupferfolie 26 mit flüssigem Silikonkautschuk oder Polyurethan als Dielektrikum beschichtet. Diese Beschichtung kann mittels Gießen (wie bei Lötstopplack), Sprühen, Schleudern, Walzen oder dergleichen erfolgen. Anschließend wird eine zweite Kupferfolie 27 auf das noch flüssige Dielektrikum auflaminiert. Alternativ dazu kann auch eine Kupferschicht auf das bereits ausgehärtete Dielektrikum aufgebracht werden. Anschließend wird das elastische Dielektrikum ausgehärtet. Danach werden Verbindungen 22 -auch Micro-Vias genannt- in die Kupferfolien 26, 27 und das Dielektrikum mittels Laserstrukturierung -beispielsweise durch Laserbohren- zur Erzeugung einer ersten Durchkontaktierungsebene eingebracht. Zusätzlich können die Metallschichten noch photo- oder ätzstrukturiert werden.

Je nach Bedarf können zur Erzeugung dickerer Kontaktiervorrichtungen 20 die bisher beschriebenen Verfahrensschritte mehrmals wiederholt werden. Es entsteht ein elektrischer Andruckverbinder 21 mit der in Fig.3 dargestellten Struktur. Nach dem Aushärten der Dielektrikumsschichten wird die zuletzt aufgebrachte Dielektrikumsschicht, das heißt die außen liegende Dielektrikumsschicht, mit einer oder mehreren Lagen Fotofolie beschichtet. Die Fotofolien und je nach Bedarf die Dielektrikumsschichten werden zur Bildung der Verbindungen 22 lasersrtukturiert. Anschließend werden auf der Oberseite 23 und der Unterseite 24 des elektrischen Andruckverbinders 21 Kontakte galvanisch aufgebracht und galvanisch vergoldet. Dann werden eine oder mehrere Fotofolien auf der Oberseite 23 und der Unterseite 24 des elektrischen Andruckverbinders 21 aufgebracht. Diese Fotofolien dienen zum einen als Schutz für die Kontakte, und zum anderen als Ausgangsmaterial für die nachfolgende Erzeugung der Kontaktpunkte 25.

Nun werden die Fotofolien zur Erzeugung der Kontaktpunkte 25 laserstrukturiert. Anschließend werden die Kontaktpunkte 25 auf den Kontakten galvanisch aufgebaut und danach galvanisch vergoldet. Die Fotofolien werden gestrippt und anschließend wird eine abschließende Ätzstrukturierung der Oberseite 23 und der Unterseite 24 vorgenommen. Die resultierende Kontaktiervorrichtung 20 kann zum Ankontaktieren von verschiedenen elektrischen Bauelementen eingesetzt werden.

## Patentansprüche

1. Kontaktiervorrichtung zur elektrischen Kontaktierung von Bauelementen, mit
einem Andruckverbinder (21), der ein elastisches Dielektrikum aufweist,
mit Kontaktpunkten (25) auf einer Oberseite (23) und einer Unterseite (24) des Andruckverbinders (21) und
mit elektrisch leitenden Verbindungen (22), die jeweils eine Anzahl dieser Kontaktpunkte (25) miteinander verbinden,
**dadurch gekennzeichnet, dass**
das elastische Dielektrikum in mindestens einer Schicht vorhanden ist,
zumindest eine Schicht des Dielektrikums an einer Oberseite oder einer Unterseite mit einer strukturierten Metallschicht (26, 27) versehen ist und
die Verbindungen (22) die Metallschicht (26, 27) mit Kontaktpunkten (25) auf der gegenüberliegenden Unterseite bzw. Oberseite der Schicht des Dielektrikums verbinden.

2. Kontaktiervorrichtung nach Anspruch 1, bei der zumindest eine Schicht des Dielektrikums an der Oberseite und der Unterseite mit einer strukturierten Metallschicht (26, 27) versehen ist und
die Verbindungen (22) die Metallschichten (26, 27) miteinander verbinden.

3. Kontaktiervorrichtung nach Anspruch 1 oder 2, bei der mindestens zwei Schichten des Dielektrikums vorhanden sind, eine Metallschicht (26, 27) zwischen zwei Schichten des Dielektrikums angeordnet ist und
die Verbindungen (22) Kontaktpunkte (25), die bezüglich der Schichten seitlich zueinander versetzt sind, über die Metallschicht (26, 27) miteinander verbinden.

4. Kontaktiervorrichtung nach einem der Ansprüche 1 bis 3, bei der
alle Oberseiten und Unterseiten der Schichten des Dielektrikums mit einer jeweiligen strukturierten Metallschicht (26, 27) versehen sind und
die Verbindungen (22) je zwei Metallschichten miteinander verbinden.

5. Kontaktiervorrichtung nach einem der Ansprüche 1 bis 4, bei der
Kontaktpunkte (25) vorhanden sind, die auf derselben Oberseite (23) oder Unterseite (24) des Andruckverbinders (21) nebeneinander angeordnet und über die Verbindungen (22) miteinander verbunden sind.

6. Kontaktiervorrichtung nach einem der Ansprüche 1 bis 5, bei der
das elastische Dielektrikum aus Silikonkautschuk oder Polyurethan gebildet ist.

7. Kontaktiervorrichtung nach einem der Ansprüche 1 bis 6, bei der
die Oberflächen der Kontaktpunkte (25) einen Goldüberzug aufweisen.

8. Kontaktiervorrichtung nach einem der Ansprüche 1 bis 7, bei der
zumindest einige der Verbindungen (22) in lösbarem Kontakt zu anderen Verbindungen (22) in dem Andruckverbinder (21) angeordnet sind.

9. Verfahren zur Herstellung einer Kontaktiervorrichtung zur elektrischen Kontaktierung von Bauelementen, bei dem
in einem ersten Schritt eine Schicht aus einem elastischen Dielektrikum auf zumindest einer Oberseite oder Unterseite mit einer Metallschicht (26, 27) versehen wird,
in einem zweiten Schritt das Dielektrikum strukturiert wird und
in einem dritten Schritt eine Anzahl von elektrisch leitenden Verbindungen (22) durch das Dielektrikum hindurch hergestellt wird, mit denen eine Anzahl von Kontaktpunkten (25) auf der Oberseite und Unterseite miteinander verbunden werden.

10. Verfahren nach Anspruch 9, bei dem
in dem ersten Schritt auf die Oberseite und die Unterseite der Schicht aus dem Dielektrikum je eine Metallschicht (26, 27) aufgebracht wird.

11. Verfahren nach Anspruch 9 oder 10, bei dem
mindestens eine weitere Schicht aus dem Dielektrikum strukturiert und mit elektrisch leitenden Verbindungen versehen wird und
die Schichten aus dem Dielektrikum so miteinander verbunden werden, dass Kontaktpunkte (25) auf der Oberseite der obersten Schicht mit Kontaktpunkten (25) auf der Unterseite der untersten Schicht elektrisch leitend verbunden werden.

12. Verfahren nach Anspruch 11, bei dem
die Schichten aus dem Dielektrikum beidseitig mit einer Metallschicht (26, 27) versehen werden und
die Schichten miteinander verbunden werden, indem die Metallschichten galvanisch aneinander ankontaktiert werden.

13. Verfahren nach einem der Ansprüche 9 bis 12, bei dem die elektrisch leitenden Verbindungen (22) als Micro-Vias hergestellt werden.

## Claims

1. Contact-making device for making electrical contacts between components, with a zero-insertion-force connector (21), which has an elastic dielectric, with contact points (25) on an upper side (23) and an underside (24) of the zero-insertion-force connector (21) and with electrically conducting connections (22) which respectively connect a number of these contact points (25) to one another, **characterized in that** the elastic dielectric is present in at least one layer, at least one layer of the dielectric is provided on an upper side or an underside with a structured metal layer (26, 27) and the connections (22) connect the metal layer (26, '27) to contact points (25) on the oppositely lying underside or upper side of the layer of the dielectric.

2. Contact-making device according to Claim 1, in which at least one layer of the dielectric is provided on the upper side and/or the underside with a structured metal layer (26, 27) and the connections (22) connect the metal layers (26, 27) to one another.

3. Contact-making device according to Claim 1 or 2, in which at least two layers of the dielectric are present, a metal layer (26, 27) is arranged between two layers of the dielectric and the connections (22) connect contact points (25) which are offset laterally in relation to one another with respect to the layers to one another via the metal layer (26, 27).

4. Contact-making device according to one of Claims 1 to 3, in which all the upper sides and undersides of the layers of the dielectric are provided with a respective structured metal layer (26, 27) and the connections (22) in each case connect two metal layers to each other.

5. Contact-making device according to one of Claims 1 to 4, in which there are contact points (25) which are arranged next to one another on the same upper side (23) or underside (24) of the zero-insertion-force connector (21) and are connected to one another via the connections (22).

6. Contact-making device according to one of Claims 1 to 5, in which the elastic dielectric is formed from silicone rubber or polyurethane.

7. Contact-making device according to one of Claims 1 to 6, in which the surfaces of the contact points (25) have a gold coating.

8. Contact-making device according to one of Claims 1 to 7, in which at least some of the connections (22) are arranged in releasable contact with respect to other connections (22) in the zero-insertion-force connector (21).

9. Process for producing a contact-making device for. making electrical contacts between components, in which, in a first step, a layer of an elastic dielectric is provided on at least one upper side or underside with a metal layer (26, 27), in a second step, the dielectric is structured and, in a third step, a number of electrically conducting connections (22) are established through the dielectric, by which connections a number of contact points (25) on the upper side and underside are connected to one another.

10. Process according to Claim 9, in which, in the first step, a metal layer (26, 27) is in each case applied to the upper side and the underside of the layer of the dielectric.

11. Process according to Claim 9 or 10, in which at least one further layer of the dielectric is structured and provided with electrically conducting connections and the layers of the dielectric are connected to one another in such a way that contact points (25) on the upper side of the uppermost layer are connected in an electrically conducting manner to contact points (25) on the underside of the lowermost layer.

12. Process according to Claim 11, in which the layers of the dielectric are provided on both sides with a metal layer (26, 27) and the layers are connected to one another by contacts being electrolytically made between the metal layers.

13. Process according to one of Claims 9 to 12, in which the electrically conducting connections (22) are produced as micro-vias.

## Revendications

1. Dispositif d'établissement de contacts électriques entre des composants, comportant
un connecteur à pression (21) qui possède un diélectrique élastique,
des points de contact (25) sur une face supérieure (23) et une face inférieure (24) du connecteur à pression (21) et
des liaisons électroconductrices (22) qui relient chacune un certain nombre de ces points de contact (25),
**caractérisé en ce que** du diélectrique élastique est présent en au moins une couche,
**en ce que** la face supérieure ou la face inférieure d'au moins une couche de diélectrique est dotée d'une couche métallique (26, 27) présentant des structures et
**en ce que** les liaisons (22) relient la couche métallique (26, 27) aux points de contact (25) sur la face inférieure ou la face supérieure opposées de la couche de diélectrique.

2. Dispositif d'établissement de contacts selon la revendication 1, dans lequel la face supérieure et la face inférieure d'au moins une couche de diélectrique est dotée d'une couche métallique (26, 27) présentant des structures et dans lequel les liaisons (22) relient les couches métalliques (26, 27) entre elles.

3. Dispositif d'établissement de contacts selon la revendication 1 ou 2, dans lequel il y a au moins deux couches de diélectrique, dans lequel une couche métallique (26, 27) est interposée entre les deux couches de diélectrique et dans lequel les dispositifs d'établissement de contacts (22) relient entre eux par la couche métallique (26, 27) des points de contact (25) qui sont décalés latéralement les uns des autres par rapport aux couches.

4. Dispositif d'établissement de contacts selon l'une des revendications 1 à 3, dans lequel toutes les faces supérieures et toutes les faces inférieures des couches de diélectrique sont dotées d'une couche métallique correspondante (26, 27) présentant des structures et dans lequel chacune des liaisons (22) relient deux couches métalliques entre elles.

5. Dispositif d'établissement de contacts selon l'une des revendications 1 à 4, dans lequel il y a des points de contacts qui sont disposés les uns à côté des autres sur la même face supérieure (23) ou la même face inférieure (24) du connecteur à pression (21) et qui sont reliés entre eux par les liaisons (22).

6. Dispositif d'établissement de contacts selon l'une des revendications 1 à 5, dans lequel le diélectrique élastique est fabriqué à partir de caoutchouc siliconé ou de polyuréthanne.

7. Dispositif d'établissement de contacts selon l'une des revendications 1 à 6, dans lequel les surfaces supérieures des points de contact (25) comporte un revêtement d'or.

8. Dispositif d'établissement de contacts selon l'une des revendications 1 à 7, dans lequel quelques unes des liaisons (22) sont en contact amovible avec d'autres liaisons (22) dans le connecteur à pression (21).

9. Procédé de fabrication d'un dispositif d'établissement de contacts électriques entre des composants, dans lequel
dans une première étape la face supérieure ou la face inférieure d'au moins une couche de diélectrique élastique est dotée d'une couche métallique (26, 27),
dans une deuxième étape le diélectrique est doté de structures et
dans une troisième étape un certain nombre de liaisons électroconductrices (22) est réalisé à travers le diélectrique au moyen desquelles un certain nombre de points de contact (25) sur la face supérieure et sur la face inférieure sont reliés entre eux.

10. Procédé selon la revendication 9, dans lequel dans la première étape une couche métallique (26, 27) est déposée sur la face supérieure et la face inférieure de la couche de diélectrique.

11. Procédé selon la revendication 9 ou 10, dans lequel au moins une autre couche de diélectrique est dotée de structures et de liaisons électroconductrices et dans lequel les couches de diélectrique sont reliées entre elles de sorte que des points de contact (25) sur la face supérieure de la couche supérieure sont reliés électriquement à des points de contact (25) sur la face inférieure de la couche inférieure.

12. Procédé selon la revendication 11, dans lequel les couches de diélectrique sont dotées sur les deux faces d'une couche métallique (26, 27) et dans lequel les couches sont reliées entre elles en établissant des contacts entre les couches métalliques par électrolyse.

13. Procédé selon l'une des revendications 9 à 12, dans lequel les liaisons électroconductrices (22) sont réalisées sous forme de Micro-Vias.
